# EUROPEAN PATENT APPLICATION

(11) **EP 0 744 779 A2**
(43) Date of publication of application: **27.11.1996**
(21) Application number: 96303491.3
(22) Date of filing: 16.05.1996
(51) Int. Cl.: H01L 31/18, H01L 31/0296, C23C 14/06

(54) **A manufacturing method of compound semiconductor thinfilms and photoelectric device or solar cell using the same compound semiconductor thinfilms**

(30) Priority: 17.05.1995 JP 118167/95; 06.09.1995 JP 228775/95; 29.01.1996 JP 12550/96
(71) Applicant: MATSUSHITA ELECTRIC INDUSTRIAL CO., LTD., Kadoma-shi, Osaka 571 (JP)
(72) Inventor: Omura, Kuniyoshi, Ikoma-shi, Nara 630-02 (JP); Nishio, Tsuyoshi, Nishinomiya-shi, Hyogo 663 (JP); Shibutani, Satoshi, Moriguchi-shi, Osaka 570 (JP); Kondoh, Shigeo, Hirakata-shi, Osaka 573 (JP); Murozono, Mikio, Hirakata-shi, Osaka 573 (JP); Hanafusa, Akira, Osaka 573 (JP); Oyama, Hideaki, Neyagawa-shi, Osaka 572 (JP)
(74) Representative: Crawford, Andrew Birkby

(57) **Abstract**

This invention relates to a manufacturing method of compound semiconductor thinfilm derived from metal sulfide produced by thermal decomposition of a metal organic compound containing at least one radical combining at least one metal element selected out of a group of copper, zinc, cadmium, mercury, and lead, and at least one sulfur element. Since thus obtained metal sulfides are of high-purity and dense, these can be utilized as various photoelectric devices. Particularly, the photoelectric conversion efficiency of CdS/CdTe system thinfilm compound semiconductor solar cell can be improved remarkably by employing a layer made of CdS thinfilm as a window of solar cell.

## Description

### BACKGROUND OF THE INVENTION

### Field of the Invention

This invention relates to a method to manufacture compound semiconductor thinfilms consisting mainly of metal sulfides, and relates to photoelectric devices and particularly to solar cells using the same compound semiconductor thinfilms.

### Description of the Prior Arts

The compound semiconductors consisting of metal sulfides such as copper sulfide or CuS, cadmium sulfide or CdS, mercury sulfide or HgS, lead sulfide or PbS, etc., had been used extensively as the photoelectric device materials in the field of photoelectric device industry. For example, CdS thinfilm had been used to construct a photoconductive sensor by utilizing the change of electrical resistance caused by the irradiation of light or an optical filter.

Whereas various manufacturing methods of CdS/CdTe system compound semiconductor solar cells comprised of the films of cadmium sulfide or CdS, and cadmium telluride or CdTe, had been reported, and a practical method manufacturing said solar cells where the entire film forming processes are carried out by a printing and sintering had been disclosed in Japanese Patent Publication No. Sho 56-28386.

Conventionally, the printing and sintering method and the chemical deposition method had been well known as the methods to form CdS films. In the process of the former printing and sintering method, a paste produced by mixing and kneading of fine particles of CdS, added with powder of cadmium chloride or CdCl₂ acting as a flux or sintering agent and propyleneglycol or PG acting as a dispersive medium for example, is coated on a substrate in a form of film by a screen printing method, and this coated film is dried and sintered afterward.

This method is highly advantageous because of its relatively low cost of the manufacturing equipment, excellent reproducibility, and a capability of continuous production of CdS layer in a form of relatively large area and in a desired shape and size. However, it is inevitable to use a substrate of high heat resistance and chemical stability such as a ceramic sheet of alumina or a barium borosilicate glass because of a required high sintering temperature of about 700°C.

Moreover, the method is definitely disadvantageous for mass production since the sintering has to be performed in an inert atmosphere such as nitrogen gas and the coated substrate has to be processed within an expensive ceramic case in order to suppress the evaporation rate of flux CdCl₂ coated with the CdS paste, and a sintering period required for this should be more than 2 hours at least.

Furthermore, the sintered CdS layer is a thick film having an uneven thickness in a range of 20 - 60 µm and a number of void spaces or pinholes so that this layer can hardly be said as a homogeneous layer, and the adhesion strength between the CdS layer and the substrate is not adequate. In addition to this, a high photoelectric conversion efficiency can not be obtained from the photoelectric conversion device or the solar cell made of a thick CdS layer having a low light transmittance.

Since the degree of pulverization of CdS powder is limited at a particle size of 2 ∼ 4 µm, the printing and sintering method applicable to the thinner CdS layer deposited by this method is also limited so far as the conventional manufacturing method using the particles of metal compound as its material is concerned.

The later mentioned chemical deposition method is a method by which the CdS layer is deposited on a substrate immersed in a solution dissolving the compounds of cadmium Cd and sulfur S. Although a CdS thinfilm of large area can be obtained by this method, the obtained CdS film can hardly be said as a homogenous film. Moreover, since the deposition is made not only on a desired and limited area, the area unrelated to the deposition such as the back of substrate for example, has to be excluded from the depostion in advance by applying a mask thereon before the deposition, or the cleaning of vessels and equipments have to be carried out every time before the deposition process, or the renewal of solution has to be made. Therefore, this method had been considered impracticable to be applied to a high speed continuous production of CdS film.

Beside these methods, the film forming of compound semiconductor by vacuum evaporation, sputtering, and CVD methods had been known, and by using either of these methods, the desired film property and film thickness can be obtained. However, since all of these methods have to be conducted in a vessel kept in vacuum, these are not suitable to continuous deposition of large area and uniform thinfilms at high-speed. If the investments enabling the deposition of this thinfilm by any of these methods were made, the amount necessary for this large scale and complex equipments would be prohibitively high.

The present invention is to solve not only these number of problems involved in the conventional methods but to offer a new deposition method of uniform semiconductor thinfilms. Moreover, this is to offer various photoelectric devices made of metal sulfides by means of a method producing a compound semiconductor thinfilm, and to offer low coat solar cells having high photoelectric conversion efficiencies using CdS thinfilm as a window layer.

### SUMMARY OF THE INVENTION

The first objective of this invention is to offer a method to produce uniform and large area thinfilms of compound semiconductor such as metal sulfide continuously using a relatively low-cost production equipment operated in a normal atmospheric condition without using conventional and expensive vacuum devices and an atmosphere of high-temperature inert-gas such as nitrogen.

Namely, this is to offer a new method to deposit compound semiconductor thinfilms derived from metal sulfides obtained by applying a thermal decomposition process to a metal organic compound containing at least one metal element selected out of a group of copper, zinc, cadmium, mercury, and lead, and one radical combined with at least one sulfur element per molecule on the surface of thinfilm forming substrate.

The second objective of the present invention is to offer photoelectric devices made of compound semiconductor thinfilms such as the film of metal sulfide produced by the above-mentioned manufacturing method deposited on a conductive electrode on the thinfilm forming substrate. Furthermore, this is to offer low cost solar cells of compound semiconductor films having a high photoelectric conversion efficiency using the CdS layer as a window layer manufactured by the invented manufacturing method.

### BRIEF DESCRIPTION OF THE DRAWINGS

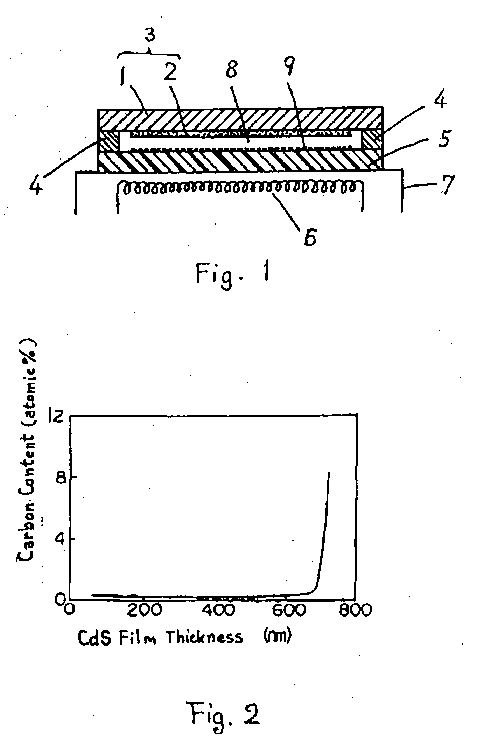

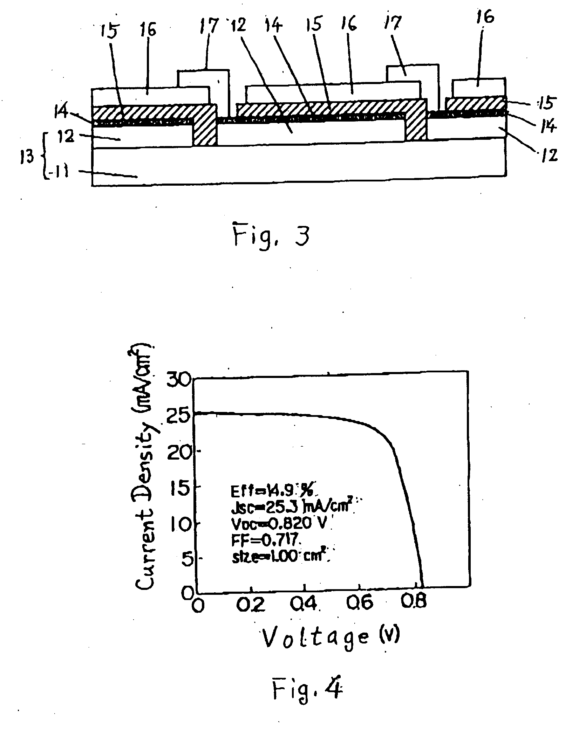

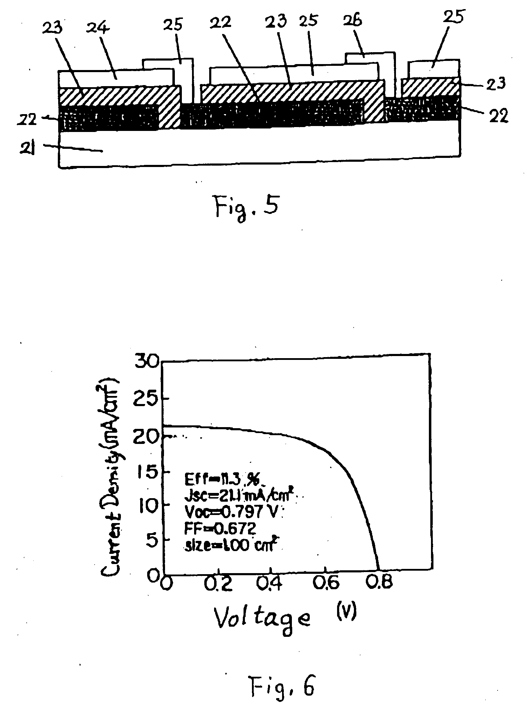

Fig. 1 shows a schematic drawing of the invented device to deposit the compound semiconductor thinfilms, Fig. 2 shows a relationship between the thickness of CdS thinfilm and the carbon content therein, and Fig. 3 shows a cross-section of CdS/CdTe system solar cell made of a compound semiconductor thinfilm deposited by the present invention, provided further with a window layer made of a CdS thinfilm, Fig. 4 shows a voltage - current characteristics of the invented CdS/CdTe system compound semiconductor solar cell, Fig. 5 shows a cross-section of CdS/CdTe system thickfilm compound semiconductor solar cell manufactured by a conventional printing and sintering method showing its structure, and Fig. 6 shows a voltage - current characteristics of the solar cell of conventional CdS/CdTe system thickfilm compound semiconductor.

### DETAILED DESCRIPTION OF THE PREFERRED EMBODIMENTS

### Examples

The detail of the present inventions are described below by referring the attached drawings and tables.

### Example-1

A paste is prepared first by adding and mixing one liter of dispersive medium PG (propyleneglycol) into a volume of 1.75 mol of cadmium diethyl dithiocarbamate powder which is a metal organic compound. This paste is then coated on a surface of glass substrate at a density of 6.4 mg/cm² in a predetermined pattern prepared by means of a screen printing method, and this is heated at a temperature of 120°C in order to evaporate and remove the dispersive medium obtaining a metal organic compound supplying substrate.

On the other hand, a thinfilm forming substrate consisted of a transparent conductive electrode made of a 200 nanomoter(nm) thick indium-tin oxide (ITO) film deposited on a surface of soda-lime glass plate is prepared. Then, a CdS thinfilm is formed by using the invented compound semiconductor film deposition device shown in Fig. 1. By using the device shown in Fig. 1, the metal organic compound supplying substrate 3 consisting of glass plate 1 on which cadmium diethyldithiocarbamate 2 is coated is disposed on thinfilm forming substrate 5 made of soda-lime glass on which a transparent conductive film is deposited, and is fixed through spacer 4 holding a gap space of 1.0 mm.

Holding this condition, thinfilm forming substrate 5 is placed on heating plate 7 integtrating heating wire 6 whthin and is heated to a temperature of 450°C. Thus, metal organic compound supplying substrate 3 facing to thinfilm forming substrate 5 at a close distance is heated by thermal radiation from heated thinfilm forming substrate 5 bringing the temperature of metal organic compound suppying substrate to a temerature of 300°C.

Therefore, the coated cadmium diethyldithiocarbamate 2 having a melting point of 250°C is melted and evaporated in next, and is deposited on the electrode predeposited on thinfilm forming substrate 5. Thus, while this is thermally decomposed, this is grown into CdS crystal thinfilm 9 having a thickness of 70 nm.

Table 1 shows the result of measurments determining each of the optical bandgaps of CdS thinfilms obtained by changing the type of cadmium organic compound deposited on the metal organic compound supplying substrate while adjusting the distance between the thinfilm forming substrate 3 and the metal organic compound supplying substrate 5 and changing the temperature of metal organic compound supplying substrate 5. All of these thinfilm depositions have been conducted in a normal atmospheric condition without using inert-gas required in a case of thinfilm deposition made by a conventional printing and sintering method.

As shown in Table 1, the optical bandgaps of CdS thinfilms deposited by thermal deposition on a thinfilm forming substrate by evapo-rating various cadmium organic compounds are in a range of 2.41 ∼ 2.47 eV, and this coincide with the value of 2.42 eV which is the conventionally known standard value, proving the formation of high-quality CdS thinfilm with very few lattice defects.

Since all of the X-ray diffraction analyses applied on these CdS films showed peaks of (002) face, this proved that these are hexagonal CdS crystals. Furthermore, the X-ray photoelectron spectroscopic analyses applied on the Cd-S bonds of CdS thinfilm have proved a coincidence of this with the Cd-S bond in CdS single crystal. Moreover, when this CdS thinfilm is uses as a window layer of compound semiconductor solar cell, the content of carbon element inflicting an ill effect on its characteristics can be determined by using the X-ray photoelectron spectroscopic analyzer also.

**Table 1**

| Type of Cd organic compound | Temp. of metal organic compound supplying substrate(°C) | Temp. of film forming substrate(°C) | Optical bandgap (eV) | |
|---|---|---|---|---|
| | | | Standard | Measured |
| Cadmium diethyl dithiocarbamate | 300 | 450 | 2.42 | 2.42 |
| Cadmium dietyldithiocarbamate | 330 | 440 | " | 2.44 |
| Cadmium dibutyldithiocarbamate | 270 | 440 | " | 2.41 |
| Cadmium dibenzyldithiocarbamate | 320 | 440 | " | 2.45 |
| Cadmium mercaptide | 360 | 440 | " | 2.44 |
| Cadmium thioate | 320 | 440 | " | 2.43 |
| Cadmium dithioate | 270 | 440 | " | 2.46 |
| Cadmium thiocarbonate | 240 | 440 | " | 2.45 |
| Cadmium dithiocarbonate | 300 | 440 | " | 2.43 |
| Cadmium trithiocarbonate | 320 | 440 | " | 2.42 |
| Cadmium thiocarbamate | 310 | 440 | " | 2.47 |

The thickness of CdS thinfilm is adjustable by controlling the heating period of metal organic compound supplying substrate. The carbon contents in the CdS thinfilm having various thicknesses are shown in Fig. 2 showing a remarkable increase of carbon content when the thickness of CdS is more than 700 nm. Therefore, the CdS thinfilm used as a window layer of compound semiconductor solar cell should be kept at a thickness less than 700 nm.

In the deposition device of compound semiconductor thinfilm shown in Fig. 1, when space 8 provided between the metal organic compound supplying substrate 3 and the thinfilm forming substrate 5 is in a closed condition, CdS thinfilm 9 is deposited on the entire exposed surface of thinfilm forming substrate 5.

On the other hand, the CdS thinfilm 9 is deposited on a pattern nearly same as the pattern of metal organic compound layer 2 coated on the metal organic compound supplying substrate 3 when space 8 between the both substrates is in a non-closed condition. In another words, the pattern of CdS thinfilm can be adjusted into a desired pattern by adjusting the pattern of coated metal organic compound layer.

Since the temperatures of evaporation and thermal decomposition of various cadmium organic compounds are less than the softening temperature of soda-lime glass, there is no need to use the expensive heat resisting glass such as the barium borosilicate glass employed in the conventional printing and sintering method. Although not shown in Table 1, high quality CdS thinfilms can be obtained also when various cadmium organic compounds are mixed in use.

### (Example-2)

Same as the case of Example-1, various compound semiconductor thinfilms made of various metal sulfides can be derived by using various metal organic compounds excluding cadmium by using the thin film deposition device shown in Fig. 1. The characteristics of these films are identified by using the analyzing method shown in the case of Example-1. Table 2 shows the determined optical bandgaps of various metal sulfide thinflims.

As shown in Table 2, since the determined optical bandgaps of various metal sulfide thinfilms are nearly same as the respective standard values, and this proves the depositions of high-quality metal sulfide thinfilm with few lattice defects by this method.

Although not shown in Table 2, high-quality zinc-cadmium sulfide thinfilm can be obtained even when the zinc diethyldithiocarbamate and the cadmium diethyldithiocarbamate are homogenously mixed at a predetermined ratio, and this mixture is coated on a metal organic compound supplying substrate by the method shown in Example-1.

**Table 2**

| Type of metal organic compound | Produced sulfide | Temp. of metal organic compound supply substrate(°C) | Temp. of film forming substrate(°C) | Optical bandgap (eV) | |
|---|---|---|---|---|---|
| | | | | Standard | Measured |
| Copper diethyldithiocarbamate | Cu₂S | 310 | 380 | 1.2 | 1.7 |
| Zinc diethyldithiocarbamate | ZnS | 305 | 500 | 3.5 | 3.6 |
| Mercury diethyldithiocarbamate | HgS | 250 | 330 | 1.9 | 1.8 |
| Lead diothylthiocarbamate | PbS | 330 | 550 | 0.37 | 0.38 |

As explained in Examples -1 and -2, the metal organic compounds applicable to the invented of evaporation and thermal decomposition method can be single substances or mixtures of mercaptide, thioate, dithioate, thiocarbonate, dithiocarbonate, trithiocarbonate, thiocarbamate, and dithiocarbamate of at least one metal element selected out of a metal group of copper, zinc, cadmium, mercury, and lead. In another words, the compounds containing at least one radical of the before-mentioned metal elements combined with at least one sulfur element per molecule, or the compounds containing at least carbon and nitrogen elements beside said metal elements and sulfur element are applicable.

### (Example-3)

In here, cadmium isopropylxanthate as a metal organic compound is dissolved first in an organic solvent of 1-methyl-2-pyrrolidone at a concentration of 1.2 mol/ℓ in order to prepare a solution of this having an approximate viscosity of 50 centipoise (cP) after the insolvable residue left in the solution is removed by a centrifugal separator. Then, the prepared solution of cadmium organic compound is coated on a transparent electrode made Of tinoxide SnO disposed on a soda-lime glass plate having a size of 35 cm square at a thickness of about 600 nm by means of flexographic printing method, and this is dried in a normal atmosphere kept at a temperature of about 110°C in order to purge the solvent.

After this, the substrate on which cadmium organic compound is coated is heated to a temperature of 450°C in a normal atmosphere for a period of 3 minutes. By this, the thermal decomposition of cadmium isopropylxanthate or a cadmium organic compound is finished obtaining a uniform thinfilm having a thick-ness of 300 nm. This thinfilm is analyzed by an analyzing method same as the one shown in Example-1, showing that this film is a dense and high-quality CdS thinfilm same as the one obtained by the evaporation and thermal decomposition of cadmium organic compound shown in Example-1.

The thermal decomposition reaction produced by the invented printing and thermal decomposition method shown in this example could be attributed for the dense and high-purity CdS thinfilm obtained by the dispersion and desorption of organic material first and the sequential arrangement of dispersed CdS molecules took place simultaneously on a substrate taking a form of regular CdS lattice caused.

### (Example-4)

In order to obtain a high-quality CdS thinfilm by means of the invented printing and thermal decomposition method shown in Example 3, a uniform coated layer of cadmium organic compound has to be prepared on a thinfilm forming substrate first. Thus, the uniformities of various CdS thinfilms formed by a method same as the one shown in Example-3 when the viscosity of solution is changed by changing the concentration of 1-methyl-2-pyrrolidone solution of cadmium isopropylxanthate have been evaluated, and the results of these experi-ments are summarized in Table 3.

When the concentration of the solution is 0.1 mol/ℓ and its viscosity is 3 cP, a blank part is observed in the coated layer of cadmium organic compound prepared by a printing and post drying method. Thus, it is concluded at this stage that a uniform CdS thinfilm is impossible to obtain.

When the concentration of the solution is brought to a high level of 2.4 mol/ℓ, its viscosity goes up to a high level of 120 cP also, and thus, the uniform coating becomes impossible by the flexographic printing method. Therefore, the viscosity of solution has to be regulated within a range of 5 ∼ 100 cP providing the concentration of cadmium isopropylxanthate is regulated in a range of 0.2 ∼ 2.0 mol/ℓ in order to obtain a uniform and high-purity CdS thinfilm.

**Table 3**

| Concentration (mol/ℓ) | Viscosity (cP) | Evaluation of CdS Thinfilm |
|---|---|---|
| 0.1 | 3 | No good |
| 0.2 | 5 | Good |
| 0.8 | 10 | Good |
| 1.2 | 50 | Good |
| 2.0 | 100 | Good |
| 2.4 | 120 | No good |

In Examples -3 and -4, the cases of cadmium isopropylxanthate used as a cadmium organic compound have been explained. However, other than this, a simple substance or mixture of cadmium mercaptide, thioate, dithioate, thiocarbonate, dithiocarbonate, trithiocarbonata, tiocarbamate, and dithiocarbamate such as cadmium dibenzilcarbamate, cadmium n-butyixanthate, cadmium thiobenzoate, etc. In another words, any compounds containing at least one radical in which one cadmium element and at least one sulfur element are combined in one molecule, or compounds con-taining at least one carbon element and one nitrogen element beside cadmium element and sulfur element are applicable.

Therefore, a high-quality CdS thinfilm can be obtained by adjusting the concentration of the organic solvent solution of cadmium organic compound so as to obtain a viscosity of 5 ∼ 100 cP.

As the type of the organic solvent which is not limited only to 1-methyl-2-pyrrolidone, any of polyhydric alcohol and their derivatives such as γ-butyrolactone, tetralin, N,N-dimethylformamide, dimethylsulfoxide, toluen, chloroform, alcohol group and cellosolve (ethylglycol mono-ethylether), and Carbitole (diethyleneglycol mono-ethylether), can be selected and used in a form of simple substance or mixtures.

Beside these, it is confirmed that the thickness of CdS thinfilm obtained by the invented printing and thermal decomposition method described in Examples -3 and 4 should not be more than 700 nm from the aspect of carbon content in the film when it is used as a window layer of solar cell made of compound semiconcuctor solar cell like the case of CdS film obtained by the evaporation and thermal decomposition method shown in Example-1,

The manufacturing method of cadmium sulfide by which the printing and thermal decomposition of cadmium organic compound are performed has been explained in above, it should be added that high-quality metal sulfide thinfilms can be obtained from the organic compound of at least one metal element selected from a metal group consisting of copper, zinc, cadmium, mercury, and lead by applying the game method.

Although the flexographic printing method as a printing method for coating the organic solvent solution of metal organic compound has been described in Examples -3 and -4, the printing method is not neccessarily be limited in this method but any printing methods including the relief printing, intaglio printing, litho-graphy, stencil printing, screen printing, and any of these methods can be used depending on the desired pattern of metal sulfide thinfilm.

### (Example-5)

In Example-1, a solar cell made of CdS/CdTe system thinfilm compound semiconductor shown in Fig. 3 using a 70 nm thick CdS thinfilm as its window layer deposited on an ITO electrode formed on a surface of soda-lime glass plate and its characteristics are measured. Fig. 3 shows CdTe thinfilm 15 deposited on CdS thinfilm 14 by using a proximity sublimation method which is one of the evaporation methods. In here, CdS thinfilm 14 is formed on ITO film 12 acting as an electrode, disposed on soda-lime glass 11 acting as thinfilm forming substrate 13. Then, a solar cell is completed by disposing carbon electrode 16 on CdTe thinfilm 15, and disposing a Ag-In electrode on both CdS thinfilm 14 and carbon electrode 16.

Fig. 4 shows a measured characteristics of thus completed CdS/CdTe solar cell. From this, an excellent and highly improved characteristics showing an intrinsic photoelectric conversion efficiency of 14.9% (1.00 cm²), an open voltage of 820 mV, a short circuit current density of 25.3 mA/cm², and a fill factor of 0.717 can be seen.

Fig. 5 shows a cross-sectional structure of CdS/CdTe system thickfilm compound semiconductor solar cell manufactured by a conventional printing and sintering method. Fig. 5 shows a structure of the solar cell consisting of CdS thickfilm 22 disposed on barium borosilicate glass plate 21 by the printing and sintering method, CdTe thick film 23 stacked over CdS thickfilm 22, and sequentially deposited carbon electrode 24 and Ag-In electrode 25.

Fig. 6 shows a characteristics of thus formed solar-cell. This shows also the open voltage of same solar cell obtained by a conventional method is 797 mV, the short circuit current density is 21.1 mA/cm², the fill-factor is 0.672, and the intrinsic photoelectric conversion efficiency is 11.3% (1.00 cm²).

From these results, the reason of a high conversion efficiency of CdS/CdTe solar-cell higher by about 32% over that of conventional solar cell would be attributed for the high shortwave light transmittance by small thickness of invented CdS thinfilm used as its window layer, and the low leak-current due to the high-quality and dense CdS thinfilm. In the CdS/CdTe system thinfilm compound semiconductor solar cell, although not only ITO layer con be used as the transparent conductive electrode but the tin oxide or zinc oxide system layer can be used However, a sheet resistance in this case should desirably be kept at a value less than 100 ohm/cm² because a sheet resistance more than 100 ohm/cm² may increase the internal resistance and degenerate the photoelectric characteristics of solar cell.

### (Example-6)

In this case, a 10 cm square copper plate used as a thinfilm forming substrate on which CdTe thinfilm is deposited by a proximity sublimation method is prepared first. Then, CdS/CdTe system thinfilm solar cell is deposited by a method of which process order is reversed to that of the thinfilm deposition method shown in Example-5. Namely, in this method, CdS thinfilm is deposited first on CdTe thinfilm by using a method shown in Example-1, and this is followed by a deposition of transparent conductive electrode made mainly of indium oxide. Then, a transparent silicon oxide thinfilm is deposited thereon for the purpose of sealing of solar cell. The characteristics of this solar cell show an open voltage of 770 mV, a short-circuit current density of 24.5 mA/cm², and an intrinsic photoelectric conversion efficiency of 12.3% (1.00 cm²).

### (Example-7)

In this case, on a surface of soda-lime glass used as the thinfilm forming substrate, a molybdenum electrode is deposited by a vacuum deposition method, and a copper-indium selenide (CIS) thinfilm is overlaid by a multi-element evaporation method, depositing copper, indium, and selenium simultaneously. This is followed by a deposition of CdS thinfilm on this substrate by a method similar to the one shown in Example-1 except that the temperature of thinfilm forming substrate is kept at 300°C. Then, the solar cell construction process is completed by depositing the thinfilms of zinc oxide, ITO, and silicon oxide sequentially.

The characteristics of thus constructed solar cell show an open voltage of 550 mV, a short circuit current density of 39.5 mA/cm², and an intrinsic photoelectric conversion efficiency of 11.6% (1.00 cm²).

Though, the thinfilm compound semiconductor solar cell employing the invented CdS thinfilm deposited by the evaporation and thermal decomposition method as its window layer has been described in Examples -5, -6 and -7, thinfilm compound semiconductor solar cells having characteristics nearly same as the above, can be obtained when a CdS thinfilm deposited by the printing and thermal decomposition method explained in Examples - 3 and -4 is used as the window layer.

Moreover, since the thermal decomposition temperature of cadmium organic compound is lower than the softening temperature of soda-lime glass, even a sheet of polyimide resin known as heat-resistive plastic can be used as a substrate material. A flexible solar cell applicable on a curved surface can be produced if polyimide resin sheet is used.

Although an example where copper plate is used as the thinfilm forming substrate has been shown in Example-6, even a sheet of iron or stainless steel plated by anti-corrosion and conductive metal such as copper, silver, gold, platinum, palladium, molybdenum, etc., can be used as the substrate.

It is needless to mention that various photoelectric devices such as photoconductive devices can be obtained by using thinfilms of metal sulfide such as CdS, ZnCdS₂, and PbS derived from the metal organic compounds by using the invented evaporation and thermal decomposition method or the printing and thermal decomposition method as well.

As above described in detail, the present invention is to eliminate the use of expensive substrate such as the heat-resistant glass in deposition of the metal sulfide thinfilm derived from metal organic compound, nor the use of specially prepared inert gas atmosphere for the deposition of thinfilm. Moreover, the continuous film forming of large area can be made by using a relatively low-cost equipment such as the continuous belt furnace.

Beside these many advantages, the industrial value of the present invention is very high because of the remarkably improved photoelectric conversion efficiency obtained from the thinfilm solar cell using a CdS thinfilm as its window layer over that of conventional solar cell.

## Claims

1. A manufacturing method of compound semiconductor thinfilms on a thinfilm forming substrate, where said thinfilms are derived from metal sulfides by means of thermal decomposition of a metal organic compound containing radicals produced by a combination of at least one metal element selected from the metal group of copper, zinc, cadmium, mercury, and lead, and at least one sulfur element at a density of one radical per molecule,

2. A manufacturing method of compound semiconductor thinfilms according to Claim 1, wherein a compound containing at least carbon element and nitrogen element beside at least one metal element selected from the metal group of copper, zinc, cadmium, mercury, and lead, and one sulfur element, is used as said metal organic compound.

3. A manufacturing method of compound semiconductor thinfilms according to Claim 1, wherein at least one selected from the group of mercaptide, thioate, dithioate, thiocarbonate, dithiocabonate, trithiocarbonate, thiocarbamate, and dithiocarbamate of at least one metal element selected from the metal group of copper, zinc, cadmium, mercury, and lead, is used as said metal organic compound.

4. A manufacturing method of compound semiconductor thinfilms wherein said thinfilms are deposited on a thinfilm forming substrate by thermal evaporation and deposition of said metal organic compound, and at the same time, the crystals of said metal sulfide are grown by thermal decomposition of said metal organic compound.

5. A manufacturing method of compound semiconductor thinfilms according to Claim 4, wherein the coated metal organic compound layer on a metal organic compound supplying substrate is disposed at a close distance facing to a thinfilm forming substrate kept at least a thermal decomposition temperature of said metal organic compound, and said metal organic compound supplying substrate is heated at least at an evaporation temperature of said metal organic compound.

6. A manufacturing method of compound semiconductor thinfilms according to Claim 4 or Claim 5, wherein at least one cadmium organic compound selected from the group of cadmium mercaptide, cadmium thioate, cadmium dithioate, cadmium thiocarbonate, cadmium dithiocabonate, cadmium trithiocarbonate, cadmium thiocarbamate, and cadmium dithiocarbamate is used as said metal organic compound.

7. A manufacturing method of compound semiconductor thinfilms wherein at least one metal organic compound selected from the group of mercaptide, thioate, dithioate, thiocarbonate, dithiocabonate, trithiocarbonate, thiocarbamate and dithiocarbamate of a metal element selected from the group of copper, zinc, cadmium, mercury, and lead, is dissolved in an organic solvent, and this solution is coated and dried on a thinfilm forming substrate by a printing method, and metal sulfide thinfilms are formed by thermal decomposition of the coated layer of said metal organic compound.

8. A manufacturing method of compound semiconductor thinfilms according to Claim 7, wherein at least one cadmium organic compound selected from the group of mercaptide, thioate, dithioate, thiocarbonate, dithiocabonate, trithiocarbonate, thiocarbamate, and dithiocarbamate of cadmuim element is used as said metal organic compound.

9. A manufacturing method of compound semiconductor thinfilms according to Claim 7 or Claim 8, wherein the viscosity of said solution is set in a range of 5 ∼ 100 centipoise by regulating the concentration of organic solvent solution of cadmium organic compound within a range of 0.2 ∼ 2.0 mol/ℓ.

10. A photoelectric device manufactured by a deposition of metal sulfide thinfilm obtained by using said manufacturing method of compound semiconductor thinfilms according to Claims 1 to 9 on the surface of electro-conductive electrode selected from the group of a metal including copper, silver, gold, platinum, palladium, molybdenum, etc., carbon mainly graphite and a metal oxide including tin oxide, indium-tin oxide etc, deposited in advance on an electrically insulating sheet of ceramics, gloss or rasin, which is used as a thinfilm forming substrate.

11. A compound semiconductor solar cell provided with a p-n junction formed by a deposition of p-type semiconductor made of cadmium telluride by means of a printing and sintering method or an evaporation method on cadmium sulfide thinfilm by using said manufacturing method of compound semiconductor thinfilms according to Claims 1 to 9 as an n-type semiconductor window layer formed on a surface of said electrode deposited on a transparent and electrically insulating sheet such as a soda-lime glass plate or polyimide resin sheet on which a transparent conductive electrode made of a layer of tin oxide, indium-tin oxide, etc. is deposited.

12. A compound semiconductor solar cell provided with a p-n junction formed by a deposition of n-type semiconductor window layer by said manufacturing method of compound semiconductor thinfilms according to Claims 1 to 9 on a p-type semiconductor layer consist of cadmium telluride or cupper-indium selenide deposited on a surface of metal sheet consisting of cupper and iron or stainless steel which is plated by copper, silver, platinum, palladium, molybdenum or a surface of electro-insulating sheet with a conductive electrode thereon used as a thinfilm forming substrate.

13. A compound semiconductor solar cell according to Claim 11 or 12, wherein the thickness of cadmium sulfide thinfilm used as a window layer of solar cell is less than 700 nm.
